Europäisches Patentamt

(19) European Patent Office

Office européen des brevets

(11) Publication number : **0 409 374 B1**

# (12) EUROPEAN PATENT SPECIFICATION

(45) Date of publication of patent specification :
**19.07.95 Bulletin 95/29**

(51) Int. Cl.[6] : **H03K 17/06,** H03K 17/693, H01P 1/18

(21) Application number : **90302902.3**

(22) Date of filing : **16.03.90**

(54) **A Microwave or Millimetre Wave Circuit.**

(30) Priority : **18.07.89 JP 185295/89**

(43) Date of publication of application :
**23.01.91 Bulletin 91/04**

(45) Publication of the grant of the patent :
**19.07.95 Bulletin 95/29**

(84) Designated Contracting States :
**DE FR GB**

(56) References cited :
**FR-A- 2 607 643
US-A- 3 909 751
US-A- 4 605 912
IEEE TRANSACTIONS ON ELECTRON DE-
VICES vol. ED-32, no. 12, December 1985,
pages 2760-2765, New York, US; C. ANDRICOS
et al.: "C-Band 6-Bit GaAs Monolithic Phase
Shifter"**

(73) Proprietor : **MITSUBISHI DENKI KABUSHIKI
KAISHA
2-3, Marunouchi 2-chome
Chiyoda-ku
Tokyo (JP)**

(72) Inventor : **Sasaki, Yoshinobu, c/o Mitsubishi
Denki K.K.
Optelectronic and Microwave Devices R & D
Lab.
1 Mizuhara 4-chome, Itami-shi, Hyogo-ken (JP)**

(74) Representative : **Beresford, Keith Denis Lewis
et al
BERESFORD & Co.
2-5 Warwick Court
High Holborn
London WC1R 5DJ (GB)**

EP 0 409 374 B1

## Description

FIELD OF THE INVENTION

The present invention relates to microwave circuits, and more particularly to control circuits utilized in a switch or a phase shifter in microwave or millimeter wave band.

BACKGROUND OF THE INVENTION

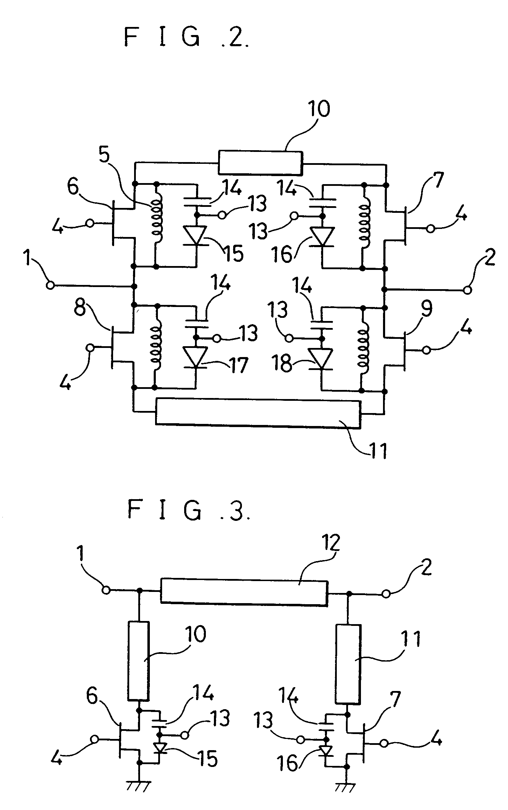

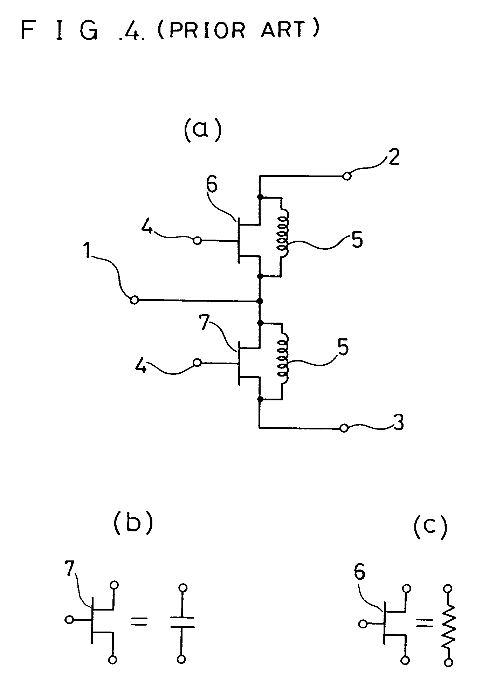

Figure 4(a) shows a circuit construction of a prior art microwave switch as e.g. known from figure 2 of patent document FR-A-2607643. In figure 4(a), denoted at 1 is an RF input terminal. Denoted at 2 and 3 are a first and a second RF terminals, respectively. A first and a second FET 6, 7 are connected between the RF input terminal 1 and the RF output terminals 2, 3, respectively. Denoted at 4 are gate terminals of the FET 6 and the FET 7, respectively. Inductances 5 are connected in parallel with the FET 6 and the FET 7, respectively.

Figure 4(b) shows an equivalent circuit of an FET in a state where the FET is off and figure 4(c) shows an equivalent circuit in a state where the FET is on.

This switch operates as follows. In order to make an RF signal input from the input terminal 1 and output from the first output terminal 2, 0V is applied to the gate terminal 4 of the FET 6 thereby to turn on the FET 6. A voltage not exceeding the FET pinch-off voltage, for example, -5 V, is applied to the gate terminal 4 of the FET 7 thereby to turn off the FET 7. Then, the FET 6 and the FET 7 are thought to be equivalent to the circuits of figures 4(c) and 4(b), respectively. Since only a resistance is inserted between the terminals 1 and 2, the RF signal transmits from the terminal 1 to the terminal 2. On the other hand, at between the terminals 1 and 3, a resonance circuit comprising the inductance 5 connected with the FET 7 and the capacitance of the FET 7 resonates at a desired frequency, and the electrical state thereof becomes similar to a state where infinite impedance is inserted thereat, therefore the RF signal does not transmit from the terminal 1 to the terminal 3. In addition, when the voltages applied to the gate terminals 4 of FETs 6 and 7 are reversed, the RF signal transmits to the second output terminal 3.

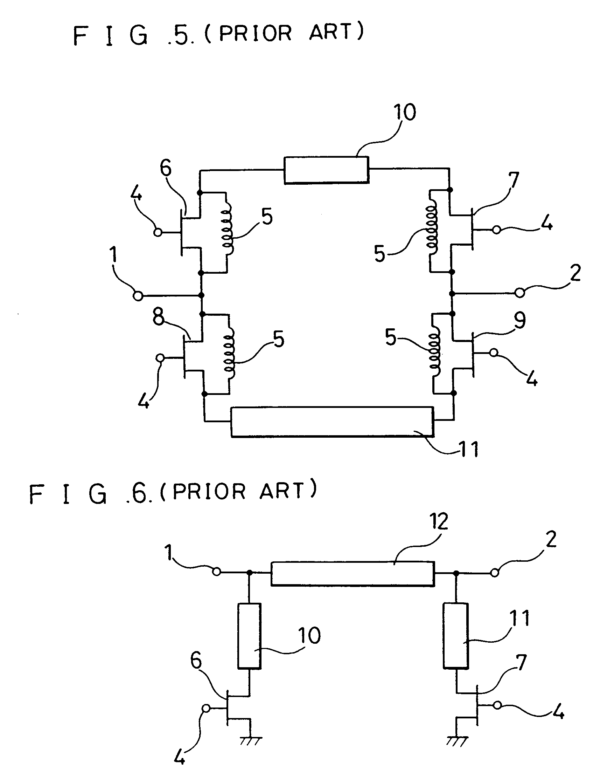

Figure 5 shows a prior art microwave switched-line type phase shifter. In figure 5, the same reference numerals denote the same elements as those shown in figure 4. Reference numerals 8 and 9 designate a third and a fourth FET, respectively. Denoted at 10 and 11 are a first and a second transmission line, respectively.

This phase shifter operates as follows. In a case where the FET 6 and the FET 7 are turned on and the FET 8 and the FET 9 are turned off by controlling the voltages applied to the gate terminal 4, the RF signal which is input from the input terminal 1 is output to the output terminal 2 through the first transmission line 10. To the contrary, in a case where the FET 6 and the FET 7 are turned off, and the FET 8 and the FET 9 are turned on, the RF signal input from the input terminal 1 transmits through the second transmission line 11. In these cases, since the transmission lines 10 and 11 have a required length difference, the phase shift amount between the two states can be varied.

Figure 6 shows a prior art loaded line type phase shifter. In figure 6, the same reference numerals denote the same elements as those shown in figures 4 and 5. Denoted at 12, is a third transmission line. This loaded line type phase shifter is constructed of a transmission line 12 of a quarter wavelength and two pairs of series connection of transmission line and FET. The parameters of the series connection pair of transmission line and FET (a pair of 10 and 6, and that of 11 and 7) are set such that the susceptance value viewed from the main line 12 is -jB in a state where the FETs 6 and 7 are on and that the susceptance value is + jB in a state where the FETs 6 and 7 are off. Then, the susceptance value B is related to the phase shift amount by,

$$B = \tan (A/2).$$

A: required phase shift quantity Then, the length of the main line 12 is set to produce such a required difference between the phase of the input signal and that of the output signal of the main line 12.

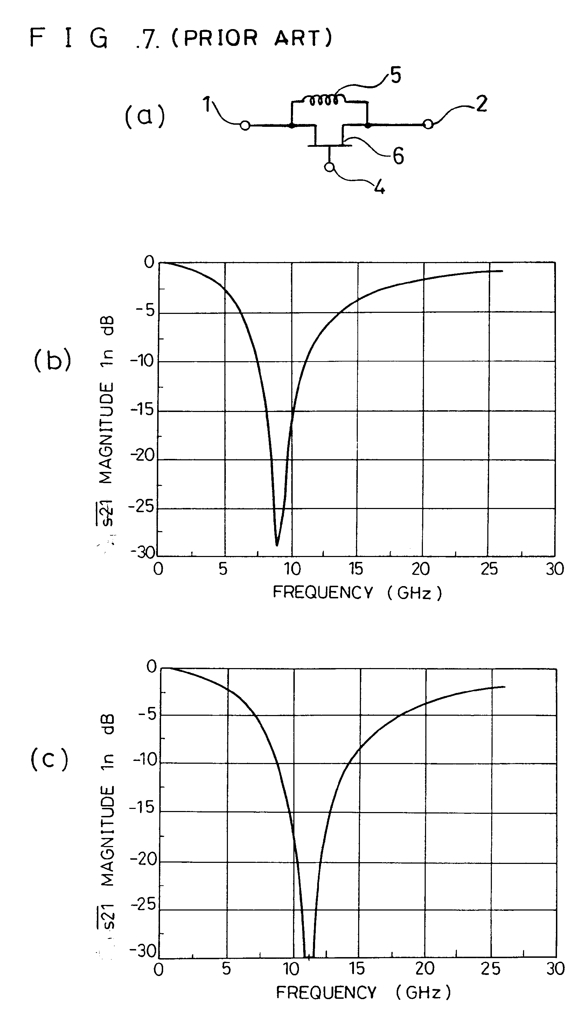

In the above-described impedance control circuit used in such as a microwave switch, a switched-line type phase shifter or a loaded-line type phase shifter, the control of the circuit is executed by using the capacitance of FET in its off state. However, this capacitance value of FET varies to a large extent due to variations in the FET fabrication process, thereby varying the circuit characteristics to a great extent. To be concrete, figures 7(b) and 7(c) show the transmission characteristics of the resonance circuit of figure 7(a) in case where the capacitance of the FET is 0.15 pF and 0.1 pF, respectively, with using the inductance 5 of 2 nH. As is apparent from these figures, when the capacitance of the FET 5 at, off state is 0.15 pF, the attenuation amount $S_{21}$ of the output terminal 2 viewed from the input terminal 1 takes the maximum at about 9 GHz, and when it is 0. 15 pF, the attenuation amount $S_{21}$ takes the maximum at about 11 GHz. Thus, the resonance frequency at which the impedance becomes infinite varies to a great extent due to the variations in the characteristics of the FET 5.

SUMMARY OF THE INVENTION

It is an object of the present invention to provide microwave circuits capable of controlling the capacitance of the FET at off state, and capable of obtaining constant uniform circuit characteristics independently of the variations in the FET characteristics.

Other objects and advantages of the present invention will become apparent from the detailed description given hereinafter; it should be understood, however, that the detailed description and specific embodiment are given by way of illustration only.

A microwave or millimetre-wave circuit in accordance with the invention is defined in claim 1 of the claims appended. In the preferred embodiment of this circuit a series connection of a diode and a capacitance is loaded in parallel to between the source and the drain of FET, and the bias voltage of the diode is controlled to adjust the capacitance between the source and the drain of FET at off state. Therefore, even when the capacitance of FET at off state varies due to the variations in the FET characteristics, the constant uniform circuit characteristics can be obtained, and the impedance control by FET can be performed at high precision.

BRIEF DESCRIPTION OF THE DRAWINGS

Figure 1(a) is a diagram showing a circuit of a microwave switch according to a first embodiment of the present invention;
Figures 1(b) and 1(c) are diagrams showing an equivalent circuit of a portion of the microwave switch when the FET is off and on, respectively;
Figure 2 is a diagram showing a circuit construction of microwave switched-line type phase shifter according to a second embodiment of the present invention;
Figure 3 is a diagram showing a circuit construction of microwave loaded-line type phase shifter according to a third embodiment of the present invention;
Figure 4(a) is a diagram showing a circuit construction of a prior art microwave switch;
Figures 4(b) and 4(c) are diagrams showing an equivalent circuit of the microwave switch of figure 4(a), when the FET is off and on, respectively;
Figure 5 is a diagram showing a circuit construction of a prior art microwave switched-line type phase shifter;
Figure 6 is a diagram showing a circuit construction of a prior art microwave loaded-line type phase shifter; and
Figures 7(a) to 7(c) are diagrams for explaining variations in the characteristics of the prior art microwave switch.

DETAILED DESCRIPTION OF THE PREFERRED EMBODIMENTS

An embodiment of the present invention will be described in detail with reference to the drawings.

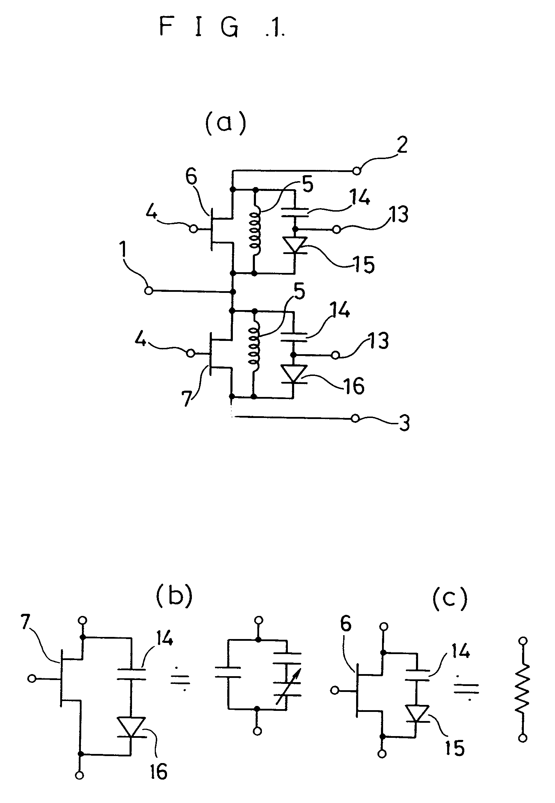

Figure 1(a) is a diagram showing a circuit construction of a microwave switch according to a first embodiment of the present invention. In figure 1(a), denoted at 1 is an RF input terminal. Denoted at 2 and 3 are a first and a second RF output terminals, respectively. A first and a second FET 6 and 7 are connected between the RF input terminal 1 and the RF output terminals 2, 3, respectively. Denoted at 4 are gate terminals of the FETs 6 and 7. Inductances 5 are connected in parallel with the FETs 6 and 7, respectively. Serial connections of a capacitor 14 and a diode 15, 16 are connected in parallel with the FET 6 and FET 7, respectively.

Figures 1(b) and 1(c) are diagrams showing an equivalent circuit of a portion of the microwave switch in a state where the FET is off and on, respectively.

This microwave switch operates as follows. In order to make an RF signal input to the input terminal 1 and output from the output terminal 2, OV is applied to the gate terminal 4 of the FET 6 to turn on the FET 6. A voltage not exceeding an FET pinch-off voltage, for example, -5 V, is applied to the gate terminal 4 of the FET 7 thereby to turn off the FET 7. Then the FET 6 and FET 7 are thought to be equivalent to the circuits of figures 1(c) and 1(b), respectively. As in the prior art, since only a resistance is inserted between the terminals 1 and 2 in that state, the RF signal transmits from the input terminal 1 to the first output terminal 2. On the other hand, at the path between the input terminal 1 and the second output terminal 3, the inductance 5 connected with the FET 7 and the capacitance of the FET 7 resonate at a desired frequency, and the electrical state thereof becomes similar to a state where infinite impedance is inserted thereat. Therefore, the RF signal does not transmit from the input terminal 1 to the second output terminal 3.

When the capacitance of the FET at off state is changed dependent upon the process variation, a voltage is applied to the diode-bias terminal 13 of the diode 16, to change the capacitance of the FET. For example, in figure 1(b), in a case where the capacitance of the FET at off state is 0.1 pF, the capacitance of the capacitor 5 pF, and the capacitance of the diode can vary from 0.05 pF to 0.,1 pF by adjusting the bias, a capacitance value from 0.15 pF to 0.198 pF is obtained by this entire control circuit. Therefore, by varying the bias voltage of the diode, the capacitance of the FET at off state can be made constant and an elements having a constant uniform characteristics can be obtained.

In addition, when the voltages applied to the gate terminals 4 of the FETs 6 and 7 are reversed, the RF signal transmits to the second output terminal 3.

In the above-described embodiment, the capacitance of the diodes 15 and 16 are adjusted so that the FETs 6 and 7 resonate with respective inductances 5 at the off states thereof, thereby to make the impedance viewed from the respective end of the FET infinite at a desired frequency, whereby a switch with constant uniform characteristics is obtained.

From a different point of view, in this embodiment, there is an advantage in that the capacitance of the diode can be varied by adjusting the bias voltage of the diode and therefore in that microwave switches with the same circuit construction can be provided at different frequency bands.

While in the above-described embodiment, an impedance control circuit is used for a microwave switch, this can be used for a switched-line type phase shifter. Figure 2 is a diagram showing a circuit construction of a microwave switched- line type phase shifter according to a second embodiment of the present invention. In figure 2, the same reference numerals denote the same elements as those shown in figure 1. Denoted at 8 and 9 are a third and a fourth FET, respectively. Denoted at 10 and 11 are a first and a second transmission line, respectively. Denoted at 17 and 18 are a third and a fourth diode, respectively.

This phase shifter operates as follows. In a state where the FETs 6 and 7 are on and the FETs 8 and 9 are off, the RF signal is input from the input terminal 1 and is output to the first output terminal 2 through the first transmission line 10. To the contrary, in a state where the FETs 6 and 7 are off and the FETs 8 and 9 are on, the RF signal transmits through the transmission line 11. In these cases, since the transmission lines 10 and 11 have a required length difference, the phase shift amount between the two states can be varied. As is the case with the switch in the above-described embodiment, even when the capacitance of the FET at off state varies, the capacitance can be varied by applying a voltage to the diode bias terminal 13 of the respective diodes, thereby resulting in a uniform element characteristics.

Figure 3 is a circuit construction of loaded-line type phase shifter according to a third embodiment of the present invention. In figure 3, the same reference numerals, denote the same elements as those shown in figures 1 and 2. Denoted at 12 is a third transmission line. A loaded-line type phase shifter as this third embodiment operates in the same way as the prior art one. That is, the capacitance of the diode can be varied by varying the diode bias voltage similarly as in the switch of the first embodiment and the switched line type phase shifter of the second embodiment. Therefore, even when the element characteristics of the FET is different dependent upon the production process, the capacitance between the source and drain of the FET at off state is made uniform, and the element characteristics is greatly enhanced.

As is evident from the foregoing description, the capacitance of an FET at off state is controlled by adjusting an impedance (e.g. a diode and series capacitance) loaded in parallel with the FET. Therefore, microwave elements with constant uniform characteristics can be obtained, and furthermore, a microwave element with the same circuit construction and a different operation frequency band can be obtained.

## Claims

1. A microwave or millimeter-wave circuit, being either a switch or a phase shifter, which circuit includes a control circuit comprised of a field-effect transistor (6,7,8,9) switchable between a resistive ON state and a capacitive OFF state, and control means, connected to the gate (4) of said field-effect transistor (6,7,8,9), to apply thereto a control signal to switch said field-effect transistor (6,7,8,9) between said resistive ON state and said capacitive OFF state;

     which microwave or millimeter-wave circuit is characterised by:

     impedance means (13,14,15; 13,14,16; 13,14,17; 13,14,18) connected between the source and the drain of said field-effect transistor (6,7,8,9), which impedance means (13,14,15; 13,14,16; 13,14,17; 13,14,18) is adjustable to compensate for process variance in the OFF state capacitance of said field-effect transistor (6,7,8,9).

2. A microwave or millimeter-wave circuit as claimed in claim 1 wherein:

     said impedance means (13,14,15; 13,14,16; 13,14,17; 13,14,18) comprises:

     a diode (15;16;17;18);

     a capacitor (14) connected in series with said diode (15;16;17;18);and

     bias means (13,-), connected to said diode (15;16; 17;18), to apply an adjustable bias voltage thereto, to adjust the capacitance of said diode (15;16;17;18).

3. A microwave or millimeter-wave circuit as claimed in either preceding claim wherein:

     said control circuit includes an inductor (5) connected in parallel with said impedance means (13,14,15; 13,14,16; 13,14,17; 13,14,18) between the source and the drain of said field-effect transistor (6,7,8,9).

4. A microwave or millimeter-wave circuit as claimed in claim 3 depending from claim 2, which circuit consists in a switch which is comprised of:

     first and second field-effect transistors (6,7), connected at a connection node, in series between first and second output terminals (2,3), each transistor being switchable between a resistive ON state and a capacitive OFF state;

     an input terminal (1) connected to said connection mode;

     first and second inductors (5) each connected between the source and the drain of respective first and second field effect transistors (6,7);

     first and second impedance means (13,14,15; 13,14,16) connected in parallel with said first and second inductors (5) respectively, each of which impedance means (13,14,15; 13,14,16) comprises:

control means, connected to respective gates (4) of said first and second field-effect transistors (6,7), to apply respective control signals to switch said first and second field-effect transistors (6,7) to ON state and OFF state respectively, and conversely; and

a respective diode (15;16);

a respective capacitor (14) connected in series with said respective diode (15;16); and

bias means (13,-) connected to said respective diode (15;16) to apply a respective adjustable bias voltage thereto, to adjust the respective capacitance of said respective diode (15;16).

5. A microwave or millimeter-wave circuit as claimed in claim 3 depending from claim 2, which circuit consists in a switched-line type phase shifter which is comprised of:

first and second transmission lines (10,11) of different electrical length;

first and second field effect transistors (6,8) connected between a common input terminal (1) and one end of each respective first and second transmission line (10,11);

third and fourth field effect transistors (7,9) connected between the other end of each respective first and second transmission line (10,11) and a common output terminal (2);

first to fourth inductors (5) each connected between the source and the drain of respective first to fourth field effect transistors (6 to 9);

control means, connected to respective gates (4) of said first to fourth field-effect transistors (6 to 9) to switch said first and third field-effect transistors (6,7) to ON state, and to switch said second and fourth field-effect transistors (8,9) to OFF state, and conversely; and

first to fourth impedance means (13,14,15; 13,14,17; 13,14,16; 13,14,18) connected in parallel with said first to fourth inductors (5), respectively, each of which impedance means (13,14,15; 13,14,17; 13,14,16; 13,14,18) comprises:

a respective diode (15,17,16,18);

a respective capacitor (14) connected in series with said respective diode (15,17,16,18); and

bias means (13,-) connected to said respective diode (15,17,16,18) to apply a respective adjustable bias voltage thereto, to adjust the respective capacitance of said respective diode (15;16).

6. A microwave or millimeter-wave circuit, as claimed in claim 2, which circuit consists in a loaded-line type phase shifter which is comprised of:

a transmission line (12);

first and second loaded lines (10,11), each of the same electrical length, connected at one end each to respective ends of said transmission line (12);

first and second field effect transistors (6,7) connected between ground and the other end of each respective first and second loaded line (10,11);

gating means connected to respective gate (4) of said first and second field-effect transistors (6,7) to apply respective control signals to switch said first and second field-effect transistors (6,7) both to one state and conversely both to OFF state; and

first and second impedance means (13,14,15; 13,14,16;) connected between the source and the drain of respective first and second field effect transistors (6,7), each of which impedance means (13,14,15; 13,14,16) comprises:

a respective diode (15;16);

a respective capacitor (14) connected in series with said respective diode (15;16) and bias means (13,-) connected to said respective diode (15;16) to apply a respective adjustable voltage thereto, to adjust the respective capacitance of said respective diode (15;16).

**Patentansprüche**

1. Mikrowellen- oder Millimeterwellen-Schaltung, die entweder ein Schalter oder ein Phasenschieber ist, wobei die Schaltung eine Steuerschaltung beinhaltet, die aus einem Feldeffekttransistor (6,7,8,9), der zwischen einem widerstandsbehafteten EIN-Zustand und einem kapazitiven AUS-Zustand umschaltbar ist, und einer Steuereinrichtung zusammengesetzt ist, die an das Gate (4) des Feldeffekttransistors (6,7,8,9) angeschlossen ist und daran ein Steuersignal anlegt, um den Feldeffekttransistor (6,7,8,9) zwischen dem widerstandsbehafteten EIN-Zustand und dem kapazitiven AUS-Zustand umzuschalten;

wobei die Mikrowellen- oder Millimeterwellen-Schaltung *gekennzeichnet ist durch:*

eine Impedanzeinrichtung (13,14,15; 13,14,16; 13,14,17; 13,14,18), die zwischen der Source und dem Drain des Feldeffekttransistors (6,7,8,9) angeschlossen ist, wobei die Impedanzeinrichtung (13,14,15; 13,14,16; 13,14,17; 13,14,18) einstellbar ist, um eine Betriebsabweichung in der Kapazität des AUS-Zustands des Feldeffekttransistors (6,7,8,9) zu kompensieren.

2. Mikrowellen- oder Millimeterwellen-Schaltung nach Anspruch 1, bei der:

die Impedanzeinrichtung (13,14,15; 13,14,16; 13,14,17; 13,14,18) aufweist:

eine Diode (15;16;17;18);

einen Kondensator (14), der in Serie zu der Diode (15;16;17;18) geschaltet ist; und

eine Vorspannungseinrichtung (13,-), die an die Diode (15;16;17;18) angeschlossen ist und eine einstellbare Vorspannung daran anlegt, um die Kapazität der Diode (15;16;17;18) einzustellen.

3. Mikrowellen- oder Millimeterwellen-Schaltung nach einem der vorhergehenden Ansprüche, bei der:

die Steuerschaltung eine Drosselspule (5) beinhaltet, die zwischen der Source und dem Drain des Feldeffekttransistors (6,7,8,9) parallel zu der Impedanzeinrichtung (13,14,15; 13,14,16; 13,14,17; 13,14,18) geschaltet ist.

4. Mikrowellen- oder Millimeterwellen-Schaltung nach Anspruch 3, der von Anspruch 2 abhängig ist, wobei die Schaltung aus einem Schalter besteht, der zusammengesetzt ist aus:

ersten und zweiten Feldeffekttransistoren (6,7), die in Serie zwischen ersten und zweiten Ausgangsausschlüssen (2,3) an einen Verbindungsknoten angeschlossen sind, wobei jeder Transistor zwischen einem widerstandsbehafteten EINZustand und einem kapazitiven AUS-Zustand umschaltbar ist;

einem Eingangsanschluß (1) der an den Verbindungsknoten angeschlossen ist;

ersten und zweiten Drosselspulen (5), wobei jede zwischen der Source und dem Drain des jeweiligen ersten bzw. zweiten Feldeffekttransistors (6,7) angeschlossen ist;

einer ersten und zweiten Impedanzeinrichtung (13,14,15; 13,14,16), die parallel zu der ersten bzw. zweiten Drosselspule (5) angeschlossen sind, wobei jede Impedanzeinrichtung (13,14,15;13,14,16) aufweist:

eine Steuereinrichtung, die an die jeweiligen Gates (4) des ersten bzw. zweiten Feldeffekttransistors (6,7) angeschlossen ist und die jeweiligen Steuersignale anlegt, um den ersten bzw. zweiten Feldeffekttransistor (6,7) in einen EIN-Zustand bzw. AUS-Zustand und umgekehrt umzuschalten; und

eine jeweilige Diode (15;16);

einen jeweiligen Kondensator (14), der zu der jeweiligen Diode (15;16) in Serie geschaltet ist; und

eine Vorspannungseinrichtung (13,-), die an die jeweilige Diode (15;16) angeschlossen ist und eine jeweilige einstellbare Vorspannung daran anlegt, um die jeweilige Kapazität der jeweiligen Diode (15;16) einzustellen.

5. Mikrowellen- oder Millimeterwellen-Schaltung nach Anspruch 3, der von Anspruch 2 abhängt, wobei die Schaltung aus einem Phasenschieber des Typs der umgeschalteten Leitung besteht, welcher zusammengesetzt ist aus:

ersten und zweiten Übertragungsleitungen (10,11) unterschiedlicher elektrischer Länge;

ersten und zweiten Feldeffekttransistoren (6,8), die zwischen einem gemeinsamen Eingangsanschluß (1) und einem Ende jeder jeweiligen ersten bzw. zweiten Übertragungsleitung (10,11) angeschlossen sind;

dritten und vierten Feldeffekttransistoren (7,9), die zwischen dem anderen Ende jeder jeweiligen ersten bzw. zweiten Übertragungsleitung (10,11) und einem gemeinsamen Ausgangsanschluß (2) angeschlossen sind;

ersten bis vierten Drosselspulen (5), wobei jede zwischen der Source und dem Drain der jeweiligen ersten bis vierten Feldeffekttransistoren (6-9) angeschlossen ist; und

einer Steuereinrichtung, die an die jeweiligen Gates (4) der ersten bis vierten Feldeffekttransistoren (6 bis 9) angeschlossen ist, um die ersten und dritten Feldeffekttransistoren (6,7) in den EIN-Zustand umzuschalten und die zweiten und vierten Feldeffekttransistoren (8,9) in den AUS-Zustand umzuschalten, und umgekehrt;

einer ersten bis vierten Impedanzeinrichtung (13,14,15;13,14,17;13,14,16;13,14,18), die jeweils zu einer der ersten bis vierten Drosselspulen (5) parallel geschaltet ist, wobei jede Impedanzeinrichtung (13,14,15;13,14,17; 13,14, 16; 13,14,18) aufweist:

eine jeweilige Diode (15,17,16,18);

einen jeweiligen Kondensator (14) der zu der jeweiligen Diode (15,17,16,18) in Serie geschaltet ist; und

eine Vorspannungseinrichtung (13,-), die an die jeweilige Diode (15,17,16,18) angeschlossen ist und eine jeweilige einstellbare Vorspannung daran anlegt, um die jeweilige Kapazität der jeweiligen Diode (15;16) einzustellen.

6. Mikrowellen- oder Millimeterwellen-Schaltung nach Anspruch 2, wobei die Schaltung aus einem Phasenschieber des Typs der belasteten Leitung besteht, welche zusammengesetzt ist aus:

einer Übertragungsleitung (12);

ersten und zweiten belasteten Leitungen (10,11), wobei jede von der gleichen elektrischen Länge ist und ein jeweiliges Ende an jeweilige Enden der Übertragungsleitung (12) angeschlossen ist;

ersten und zweiten Feldeffekttransistoren (6,7), die zwischen Masse und dem anderen Ende jeder jeweiligen ersten bzw. zweiten belasteten Leitung (10,11) angeschlossen sind;

einer Verknüpfungseinrichtung, die an das jeweilige Gate (4) des ersten bzw. zweiten Feldeffekttransistors (6,7) angeschlossen ist, und jeweilige Steuersignale anlegt, um die ersten und zweiten Feldeffekttransistoren (6,7) beide in einen Zustand und umgekehrt beide in den AUS-Zustand umzuschalten; und

einer ersten und zweiten Impedanzeinrichtung (13,14,15; 13,14,16;), die zwischen der Source und dem Drain des jeweiligen ersten bzw. zweiten Feldeffekttransistors (6,7) angeschlossen sind, wobei jede Impedanzeinrichtung (13,14,15; 13,14,16) aufweist:

eine jeweilige Diode (15;16);

einen jeweiligen Kondensator (14), der zu der jeweiligen Diode (15;16) und der Vorspannungseinrichtung (13,-), die an die jeweilige Diode (15;16) angeschlossen ist, und eine einstellbare Spannung daran anlegt, um die jeweilige Kapazität der jeweiligen Diode (15;16) einzustellen, in Serie geschaltet ist.

## Revendications

1.  Circuit à onde ultra-courte ou à onde millimétrique étant soit un interrupteur soit un déphaseur, lequel circuit comprend un circuit de commande constitué d'un transistor à effet de champ (6,7,8,9) pouvant être commuté entre un état résistif EN SERVICE et un état capacitif HORS SERVICE, et un moyen de commande, relié à la porte (4) dudit transistor à effet de champ (6,7,8,9), pour appliquer à celui-ci un signal de commande pour commuter ledit transistor à effet de champ (6,7,8,9) entre ledit état résistif EN SERVICE et ledit état capacitif HORS SERVICE;

lequel circuit à onde ultra-courte ou à onde millimétrique est caractérisé par :

un moyen d'impédance (13,14,15; 13,14,16; 13,14,17; 13,14,18) relié entre la source et le drain dudit transistor à effet de champ (6,7,8,9), lequel moyen d'impédance (13,14,15; 13,14,16; 13,14,17; 13,14,18) peut être réglé pour compenser des variations de processus dans la capacité d'état HORS SERVICE dudit transistor à effet de champ (6,7,8,9).

2.  Circuit à onde ultra-courte ou à onde millimétrique comme revendiqué en revendication 1, dans lequel :

le moyen d'impédance précité (13,14,15; 13,14,16; 13,14,17; 13,14,18) comprend :

une diode (15;16;17;18);

un condensateur (14) relié en série avec ladite diode (15;16;17;18); et

un moyen de polarisation (13,-), relié à ladite diode (15;16;17;18), pour appliquer à celle-ci une tension de polarisation réglable, pour régler la capacité de ladite diode (15;16;17;18).

3.  Circuit à onde ultra-courte ou à onde millimétrique comme revendiqué dans l'une ou l'autre des revendications précédentes, dans lequel :

le circuit de commande précité comprend un inducteur (5) relié en parallèle au moyen d'impédance précité (13,14,15; 13,14,16; 13,14,17; 13,14,18) entre la source et le drain du transistor à effet de champ précité (6,7,8,9).

4.  Circuit à onde ultra-courte ou à onde millimétrique comme revendiqué en revendication 3 dépendant de la revendication 2, lequel circuit consiste en un interrupteur qui est constitué de :

premier et second transistors à effet de champ (6,7), reliés à un noeud de connexion, en série entre les première et seconde bornes (2,3), chaque transistor étant commutable entre un état résistif EN SERVICE et un état capacitif HORS SERVICE;

une borne d'entrée (1) reliée audit noeud de connexion;

premier et second inducteurs (5), chacun relié entre la source et le drain des premier et second transistors à effet de champ respectifs (6,7);

premier et second moyens d'impédance (13,14,15; 13,14,16) reliés en parallèle respectivement avec lesdits premier et second inducteurs (5), dont chaque moyen d'impédance (13,14,15; 13,14,16) comprend :

un moyen de commande, relié au portes respectives (4) des premier et second transistors à effet de champ (6,7), pour appliquer des signaux de commande respectifs pour commuter lesdits premier et second transistors à effet de champ (6,7) à un état EN SERVICE et un état HORS SERVICE, et réciproquement; et

une diode respective (15;16);

un condensateur respectif (14) relié en série avec la diode respective (15;16); et

un moyen de polarisation (13,-) relié à ladite diode respective (15;16) pour appliquer à celle-ci une tension de polarisation réglable respective, pour régler la capacité respective de ladite diode respective (15;16).

5.  Circuit à onde ultra-courte ou à onde millimétrique comme revendiqué en revendication 3 dépendant de la revendication 2, lequel circuit consiste en un déphaseur du type à ligne commutée qui est constitué de :

première et seconde lignes de transmission (10,11) d'une longueur électrique différente;

premier et second transistors à effet de champ (6,8) reliés entre une borne d'entrée commune (1) et une extrémité de chaque première et seconde ligne de transmission respective (10,11);

troisième et quatrième transistors à effet de champ (7,9) reliés entre l'autre extrémité de chaque première et seconde ligne de transmission respective (10,11) et une borne de sortie commune (2);

premier à quatrième inducteurs (5) chacun relié entre la source et le drain des premier à quatrième transistors à effet de champ respectifs (6 à 9);

moyen de commande, relié aux portes respectives (4) desdits premier à quatrième transistors à effet de champ (6 à 9) pour commuter lesdits premier et troisième transistors à effet de champ (6,7) à un état EN SERVICE, et pour commuter lesdits second et quatrième transistors à effet de champ (8, 9) à un état HORS SERVICE, et réciproquement; et

premier à quatrième moyens d'impédance (13,14,15; 13,14,17; 13,14,16; 13,14,18) reliés en parallèle respectivement avec lesdits premier à quatrième inducteurs (5), chaque moyen d'impédance (13,14,15; 13,14,17; 13,14,16; 13,14,18) comprend :

une diode respective (15,17,16,18).

un condensateur respectif (14) relié en série avec la diode respective (15,17,16,18); et

un moyen de polarisation (13,-) relié à ladite diode respective (15,17,16,18) pour appliquer à celle-ci une tension de polarisation réglable respective, pour régler la capacité respective de la diode respective (15;16).

6. Circuit à onde ultra-courte ou à onde millimétrique, comme revendiqué en revendicaton 2, lequel circuit consiste en un déphaseur du type à ligne chargée qui est constitué de :

une ligne de transmission (12);

première et seconde lignes chargées (10,11), chacune de la même longueur électrique, reliées à une extrémité aux extrémités respectives de ladite ligne de transmission (12);

premier et second transistors à effet de champ (6;7) reliés entre la masse et l'autre extrémité de chaque première et seconde ligne chargée respective (10,11);

moyen de porte relié à la porte respective (4) desdits premier et second transistors à effet de champ (6,7) pour appliquer des signaux de commande respectifs pour commuter lesdits premier et second transistors à effet de champ (6,7) à la fois à un état EN SERVICE et inversement HORS SERVICE; et

premier et second moyens d'impédance (13,14,15; 13,14,16) reliés entre la source et le drain des premier et second transistors à effet de champ respectifs (6,7), chaque moyen d'impédance (13?14,15; 13,14,16) comprend :

une diode respective (15;16);

un condensateur respectif (14) relié en série avec la diode respective (15;16) et un moyen de polarisation (13,-) relié à ladite diode respective (15;16) pour appliquer à celle-ci une tension réglable respective, pour régler la capacité respective de ladite diode respective (15;16).

F I G .1.

(a)

(b)

(c)

F I G .2.

F I G .3.

F I G .4. (PRIOR ART)

(a)

(b)

(c)

EP 0 409 374 B1

F I G .5. (PRIOR ART)

F I G .6. (PRIOR ART)

F I G .7. (PRIOR ART)

(a)

(b)

(c)